(19) Europäisches Patentamt
European Patent Office
Office européen des brevets

(11) Numéro de publication: **0 166 665**
**A2**

(12) **DEMANDE DE BREVET EUROPEEN**

(21) Numéro de dépôt: **85420114.2**

(22) Date de dépôt: **21.06.85**

(51) Int. Cl.[4]: **H 05 K 1/03**, H 05 K 3/00, H 05 K 3/10

(30) Priorité: **25.06.84 FR 8410185**

(43) Date de publication de la demande: **02.01.86 Bulletin 86/1**

(84) Etats contractants désignés: **AT BE CH DE FR GB IT LI LU NL SE**

(71) Demandeur: **RHONE-POULENC RECHERCHES, 25 Quai Paul Doumer, F-92408 Courbevoie Cedex (FR)**

(72) Inventeur: **Cassat, Robert, Chemin de Crapon, F-69360 - Ternay (FR)**

(74) Mandataire: **Varnière-Grange, Monique et al, RHONE-POULENC RECHERCHES Service Brevets Chimie et Polymères Centre de Recherches de Saint-Fons 85, avenue des Frères Perret B.P. 62, F-69192 St-Fons Cédex (FR)**

(54) **Procédé d'obtention de plaques supports de circuits imprimés, composition pour la mise en oeuvre du procédé et plaques ainsi obtenues.**

(57) Circuits imprimés sur des supports injectés obtenus à partir de compositions polymériques contenant de 10 à 70% d'oxyde métallique non conducteur, le circuit conducteur étant révélé par réduction sélective avec un composé borohydrure.

Ces circuits ont une conductibilité thermique améliorée.

EP 0 166 665 A2

# PROCEDE D'OBTENTION DE PLAQUES SUPPORTS DE CIRCUITS IMPRIMES, COMPOSITION POUR LA MISE EN OEUVRE DU PROCEDE ET PLAQUES AINSI OBTENUES

La présente invention se rapporte à un procédé d'obtention de plaques supports de circuits imprimés, à une composition pour la mise en oeuvre du procédé. L'invention se rapporte également à de nouvelles plaques supports de circuits imprimés.

L'invention se rapporte en particulier à un procédé d'obtention de plaques supports de circuits imprimés par injection et moulage de matières plastiques.

Il est connu de fabriquer des plaques supports de circuits imprimés par moulage ou injection de matières plastiques renforcées ou non renforcées. L'article de W. ENGELMAIER dans "Electronics" du 15 décembre 1982 étudie les propriétés de telles plaques supports obtenues par injection de divers matériaux comme les polysulfones, les polyéthersulfones ou les polyétherimides ou par moulage de compositions renforcées par des fibres de verre, de résines époxy, de polyimide, de résines triazines ou de polytétrafluoroéthylène.

Le procédé d'injection permet l'obtention de plaques dans des conditions d'automaticité, de régularité et de rendement entraînant un très faible coût.

De plus la possibilite d'incorporer dans la plaque, lors de la phase d'injection des inserts comme des écrous noyés permettant la fixation de la plaque ou des connecteurs ou des renforts de forme adaptée à leur utilisation, permet d'éviter le montage ultérieur de pièces plastiques ou métalliques ainsi que d'éventuels usinages des plaques. On peut par ailleurs prévoir l'insertion de pièces métalliques qui permettront le transfert à l'extérieur et l'élimination des calories produites par les divers composants électroniques fixés sur la plaque.

Divers problèmes se posent toutefois car d'une part les matières plastiques ont des coefficients de dilatation très différents de ceux des pièces métalliques insérées et d'autre part elles n'ont pas des coefficients de transfert de la chaleur compatibles avec une bonne évacuation des calories.

De plus la réalisation par injection de substrats non plan

renfermant des bossages, inserts et/ou renforts, interdit le collage de feuillards de cuivre et l'utilisation d'un procédé soustractif. Il était donc nécessaire jusqu'à présent de faire subir à de telles plaques supports, outre les traitements de surface indispensables, les traitements classiques d'obtention des circuits imprimés par les procédés additifs, dont la complexité et le coût ne sont pas à démontrer (cf. par exemple le brevet US 3,558,441).

Il a maintenant été trouvé un nouveau procédé d'obtention de plaques supports de circuits imprimés, les nouvelles plaques ainsi obtenues permettant une élimination améliorée des calories. Les dites plaques sont obtenues par moulage d'une composition constituée essentiellement d'une matrice polymérique et d'au moins un oxyde métallique non conducteur électrique, le cas échéant en présence d'inserts et/ou de renforts.

Ces plaques qui sont susceptibles d'être obtenues par injection de composition du type indiqué ci-avant sont des supports de circuits imprimés, sur lesquels il est possible de faire apparaître des chemins conducteurs par réduction de l'oxyde métallique en cause par un borohydrure. Les chemins conducteurs ainsi révélés, qui peuvent être renforcés, sont résistants à l'arrachage même lorsque le support n'est pas plan, sans qu'il ait été pour autant nécessaire de recourir à des procédés additifs complexes.

Par matrice polymérique on entend essentiellement une matière thermoplastique ou une matière thermodurcissable ou élastomérique ayant sous forme de prépolymère un comportement thermoplastique permettant l'injection.

Parmi les matières thermoplastiques utilisables selon l'invention on citera les polyamides : Nylon 6 - Nylon 66 - Nylon 11 - Nylon 12 et les copolyamides, les polyesters saturés et leurs copolyesters : polyéthylèneglycol téréphtalate - polybutylèneglycol téréphtalate, les polycarbonates, les polymères fluorés, le polyoxyde de phénylène, les polysulfones, les polyéthersulfones, les polyphénylènesulfones, les polyacétals, les polyoléfines comme le polyéthylène ou le polypropylène, les polyétherimides.

Parmi les matières élastomériques on citera essentiellement les

silicones et les polyuréthanes.

Parmi les matières thermodurcissables on citera essentiellement les polyimides, les époxy, les phénoliques.

Il va de soi que l'énumération des différentes matières polymériques n'est pas limitative et que de nombreux copolymères ou mélanges de polymères peuvent aussi être mis en oeuvre selon l'invention.

Par oxyde métallique non conducteur, on entend les oxydes qui présentent une résistivité mesurée à 0° supérieure à $10^3$ ohm.cm. On recourt plus particulièrement à des oxydes métalliques dont le degré d'oxydation est choisi de manière à permettre une réduction facile de l'oxyde par un borohydrure et qui sont suceptibles de former intermédiairement des hydrures métalliques instables. Parmi ceux-ci on préfère utiliser les oxydes des métaux "non nobles", c'est à dire de métaux différant des métaux nobles des groupes IB et VIII de la classification périodique (telle que publiée dans "Handbook of Chemistry and Physics, 45$^{e}$ édition, 1964-1965). Des oxydes susceptibles de convenir sont en particulier l'oxyde de nickel-II, l'oxyde de cobalt-II, l'oxyde de plomb-II, l'oxyde de cadmium-II, l'oxyde de chrome-III, l'oxyde d'antimoine-III, l'oxyde d'étain-IV et l'oxyde de cuivre-I. Parmis ces derniers, on fait de préférence appel à l'oxyde de cuivre-I, encore applelé oxyde cuivreux ($Cu_2O$) dans ce qui suit. Ces oxydes doivent se présenter sous la forme de particules de très petites dimensions. Leur granulométrie est avantageusement comprise entre 0,1 et 5 micromètres.

On utilise une quantité d'oxyde métallique généralement comprise entre 10 et 70 % en poids de la composition totale et de préférence entre 30 et 55 %.

On a trouvé de manière tout à fait inattendue que la présence de grandes quantités d'oxyde métallique non conducteur et, en particulier, d'oxyde cuivreux $Cu_2O$ sous forme de poudre très fine ayant une granulométrie comprise de préférence entre 0,1 et 5 micromètres ne diminuait pas la potentialité d'injection de la composition et que cette présence peut même favoriser le moulage.

Il est possible de remplacer une partie de l'oxyde métallique non conducteur par des charges non conductrices, inertes par rapport au

processus de réduction et sans influence notable sur les propriétés thermiques de l'objet formé, comme le kaolin, la craie, le carbonate de calcium, mais il ne faudra pas que le taux de charge inerte par rapport au total des charges soit supérieur à 30 % (en poids). Il est possible aussi d'ajouter des charges renforçantes comme des fibres de verre ou des fibres organiques en polyamide aromatique. Il peut être intéressant d'introduire également des poudres métalliques à un taux suffisamment faible pour qu'elles ne soient pas en mesure d'assurer la conductibilité électrique de l'objet formé. On améliore ainsi le transfert thermique et cette introduction de poudre peut entrainer des améliorations sur les traitements ultérieurs, par exemple, le cuivre métallique peut servir de catalyseur de réduction de $Cu_2O$ par $BH_4^-$, de même l'aluminium métallique autorise une attaque à la soude, sans action sur $Cu_2O$, ce qui permet un traitement de surface intéressant.

On peut ajouter à la composition précédemment définie des additifs classiquement utilisés en injection à condition qu'ils ne modifient pas la résistivité de la pièce formée.

Ces additifs dont les fonctions peuvent être très variées (agent de démoulage, lubrifiants....) sont de nature très diverses et on pourra utilement se réferrer à des ouvrages "classiques" tel que "Encyclopedia of Polymer Science and Technology" de H.F. MARK et N.G. GAYLORD, édité par Interscience Publisher et plus particulièrement au volume 4 pages 118-123.

La préparation des compositions destinées à mettre en oeuvre l'invention peut être effectuée de plusieurs manières. On peut, par exemple, introduire l'oxyde métallique en suspension dans le monomère lors de la réalisation du polymère. On peut aussi incorporer directement l'oxyde métallique en boudineuse pour obtenir des granulés chargés. Pour cela le polymère en poudre ou en grains est humecté par un agent mouillant puis l'oxyde est introduit. Il se répartit alors à la surface du polymère qui est alimenté dans la boudineuse. L'agent mouillant servant en fait d'agent de répartition de la charge peut être éliminé si on utilise une vis dégazeuse. On obtient des joncs qui sont granulés et ces granulés servent à l'alimentation de la presse à injecter.

Il est aussi possible d'alimenter directement les grains de

polymère enrobés d'oxyde dans la presse à injecter.

Dans le cas des polymères thermodurcissables on peut incorporer l'oxyde en poudre dans le prépolymère qui subira ou non, un début de polymérisation avant utilisation en presse à injecter.

D'autres méthodes de préparation peuvent être envisagées dont le seul but final est d'assurer l'homogénité la plus complète de la teneur de l'oxyde métallique dans la matrice polymérique.

L'injection des compositions selon l'invention se fait selon les procédés classiques bien connus de l'homme de l'art. On peut avantageusement placer des inserts métalliques dans l'épaisseur de la plaque ou éventuellement sur une surface de la plaque en prenant garde que le circuit conducteur formé en surface n'entre pas en contact avec lesdits inserts. De tels inserts pourront faciliter le transfert thermique vers l'extérieur ou vers un collecteur. Il y aura lieu cependant d'être conscient des risques de court-circuit des composants enfichés sur le circuit imprimé. Avec ou sans insert métallique, on a trouvé que l'adjonction d'oxyde métallique non conducteur tel l'oxyde cuivreux permettait d'augmenter considérablement la conductivité thermique de la plaque formée.

On ne sort pas de l'invention en adaptant la mise en oeuvre à la nature de la matrice polymérique et en opérant par exemple par moulage dans la cas de thermodurcissables renforcés par des réseaux filamenteux comme des tissus ou non tissés de fibres de verre ou de polyamides aromatiques.

Les plaques supports ainsi formées subissent ensuite un traitement chimique ou mécanique permettant de décaper superficiellement la surface (élimination du film superficiel de polymère pur). Après élimination des résidus résultant du traitement précédent par lavage, on effectue le traitement permettant de révéler le circuit imprimé sur le substrat.

Deux procédés sont alors possibles qui sont connus de l'homme de l'art sous les termes de "Pattern plating" ou de "Panel plating".

Le premier procédé consiste à appliquer sur la surface un photorésist qui sera développé. Seule restera libre la surface du circuit imprimé à réaliser, le reste de la surface étant protégé par une couche

de photorésist.

On opérera alors quand on a utilisé de l'oxyde cuivreux pour fabriquer les plaques supports la réduction de l'oxyde cuivreux en cuivre, on rincera et on renforcera par un cuivrage (ou nickelage) électrolytique ou chimique ou par (électro-)dépôt d'un métal approprié. L'élimination du photorésist sera enfin effectuée. Si le renforcement a été réalisé électrolytiquement, il faudra de plus procéder à la coupure des pistes de jonction électrique.

Le deuxième procédé consiste à réduire toute la surface, puis à rincer et à appliquer le photorésist qui sera développé. Sur la surface non protégée par le photorésist correspondant au circuit à imprimer, on renforcera par exemple, par un cuivrage électrolytique. On éliminera le photorésist puis on effectuera une gravure non sélective qui permettra de rendre non conductrice toute la surface excepté le circuit imprimé renforcé. Dans ce cas la totalité de la surface est conductrice, y compris sous le photorésist et il n'est pas nécessaire de créer des pistes de jonction électrique. Le procédé de réduction de l'oxyde métallique en métal a déjà été divulgué dans le brevet français 2 516 739. Rappelons que l'on a constaté que la transformation de l'oxyde métallique et particulièrement de l'oxyde cuivreux en cuivre métallique peut être conduite facilement et de manière quantitative par action des borohydrures. La transformation est représentée par la réaction :

$$4Cu_2O + BH_4^- \longrightarrow 8Cu + B(OH)_3 + OH^-$$

Cette facilité de réaction est probablement due à l'effet catalytique du cuivre métal.

Les borohydrures utilisables dans la présente invention englobent des borohydrures substitués aussi bien que des borohydrures non substitués. Des borohydrures substitués dans lesquels au plus trois atomes d'hydrogène de l'ion borohydrure ont été remplacés par des substituants inertes par rapport à la réduction en cause comme par exemple des radicaux alkyles, des radicaux aryles, des radicaux alkoxy peuvent être utilisés. On fait appel de préférence à des borohydrures alcalins dans lesquels la partie alcaline consiste en du sodium ou du

potassium. Des exemples typiques de composés qui conviennent sont : le borohydrure de sodium, le borohydrure de potassium, le diéthylborohydrure de sodium, le triméthoxyborohydrure de sodium, le triphénylborohydrure de potassium.

Le traitement réducteur est conduit de manière simple par mise en contact du substrat avec une solution de borohydrure dans l'eau ou dans un mélange d'eau et d'un solvant polaire inerte comme par exemple un alcool aliphatique inférieur. On donne la préférence aux solutions purement aqueuses de borohydrure. La concentration de ces solutions peut varier dans de larges limites et elle se situe de préférence entre 0,05 et 1 % en poids d'hydrogène actif du borohydrure par rapport à la solution. Le traitement réducteur peut être effectué à température élevée, cependant on préfère le mettre en oeuvre à une température voisine de la température ambiante, par exemple entre 15°C et 30°C. A propos du déroulement de la réaction, il faut noter qu'elle donne naissance à du $B(OH)_3$ et à des ions $OH^-$ qui ont pour effet d'induire une augmentation du pH du milieu au cours de la réduction. Or à des valeurs de pH élevées, par exemple supérieures à 13, la réduction est ralentie de sorte qu'il peut être avantageux d'opérer dans un milieu tamponné pour avoir une vitesse de réduction bien déterminée. Aprés réduction on rince le substrat.

La durée du traitement est en général assez courte et, selon les proportions d'oxyde comprises dans le substrat, elle se situe habituellement entre environ une minute et une quinzaine de minutes. Pour une durée de traitement donnée, il est possible d'agir encore sur la vitesse de réduction en ajoutant dans le milieu des accélérateurs variés comme par exemple de l'acide borique, de l'acide oxalique, de l'acide citrique, de l'acide tartrique, de l'éthylène diamine tétracétique ou des sels de métaux tels que cobalt-II, nickel-II, manganèse-II, cuivre-II.

Par ailleurs s'il a été prévu des trous, on constate qu'une couche, au minimum de même épaisseur qu'en surface est aussi réduite sur les parois des trous.

On a également constaté qu'il est possible de stocker dans cet état le substrat réduit. On peut prévoir à titre de précaution soit un rinçage incomplet laissant des traces de réducteur à la surface du

substrat, soit l'addition au bain de rincage d'un agent réducteur particulier par exemple d'hydroquinone soit la protection du substrat rincé et séché par enduction d'un film protecteur par exemple de photorésist.

Le substrat réduit peut ensuite être métallisé par dépôt d'une couche de cuivre, de nickel ou d'un autre métal. Cette métallisation peut être faite par voie électrochimique (dépôt chimique sans courant, "métallisation chimique"), mais il a été constaté et ceci constitue un des avantages essentiels liés à la mise en oeuvre de la présente invention, qu'elle peut être faite aussi directement par voie électrolytique. Dans certaines applications, il n'est pas rare de rechercher un dépôt de couche métallique d'au moins 20 micromètres, aussi la possibilité de pouvoir utiliser directement la voie électrolytique correspond-elle vraiment à un procédé industriellement rentable. Il est possible bien entendu de procéder, de manière classique, d'abord à une métallisation chimique, puis de renforcer ce premier dépôt par un dépôt ultérieur électrolytique. Pour avoir une description détaillée des conditions opératoires propres à la métallisation chimique, on peut se reporter à l'ouvrage "Encyclopedia of Polymer Science and Technology, 1968, volume 8, pages 658 à 661". Les proportions des constituants du bain électrochimique, la durée de l'immersion du substrat, la température et les autres conditions opératoires sont déterminées dans chaque cas particulier de manière connue en soi pour obtenir les meilleurs résultats.

La métallisation par électrolyse est bien connue ; cf. notamment "Encyclopedia of Polymer Science and Technology, 1968, volume 8, pages 661 à 663". Le substrat convenablement réduit constitue la cathode et le métal à déposer l'anode. Tous deux sont immergés dans un électrolyte traversé par un courant. Par exemple dans le cas d'un cuivrage électrolytique, le métal déposé peut procéder du cuivre monovalent ou bivalent et provenir d'un électrolyte cyanuré (cuivre monovalent) ou d'un électrolyte à base de sulfate, pyrophosphate ou fluoborate (cuivre bivalent). Plusieurs adjuvants peuvent être ajoutés dans l'électrolyte : un sel alcalin ou alcalino-terreux, un acide (bain de cuivrage acide au sulfate de cuivre) ou une base (bain d'étamage alcalin au stannate) pour augmenter la conductivité de l'électrolyte ; un agent tampon pour éviter

les variations rapides du pH ; des corps modifiant la structure des électrodépôts comme par exemple des colloïdes, des agents tensio-actifs, un phénol, un phénol sulfoné, un brillanteur minéral ou organique, un agent nivelant tel que par exemple la coumarine. La qualité de l'électrodépôt, qu'il soit d'un métal ou d'un alliage métallique, va dépendre de la composition de l'électrolyte et des conditions physiques de l'électrolyse (température, densité de courant cathodique et anodique, distance anode-cathode, conditionnement superficielles des électrodes, etc.) ; le réglage de ces différents paramètres sera fait dans chaque cas particulier de manière connue en soi.

Selon la durée du traitement électrolytique on pourra obtenir des couches métalliques dont l'épaisseur est de l'ordre du micromètre, couches enracinées dans le substrat et présentant une bonne cohésion, contrairement à ce qui se passe avec des dépôts "Electroless". Des substrats comportant une couche aussi mince de métal présentent un grand intérêt pour la réalisation de circuits imprimés, car ils permettent lors des traitements ultérieurs de gravure de supprimer les défauts et notamment la sous-gravure. On peut ainsi augmenter la densité de la circuiterie et augmenter la fiabilité des circuits.

Il va de soi que l'on peut obtenir aussi des dépôts métalliques beaucoup plus importants, de l'ordre de 20 à 50 micromètres par exemple, dépôts correspondants aux techniques actuellement utilisées pour la réalisation de circuits imprimés. On peut de même déposer par fusion ou par voie électrolytique des couches d'alliages de type plomb/étain.

Les plaques supports de circuits imprimés selon l'invention présentent de nombreux avantages liés à l'utilisation des compositions définies dans le présent mémoire. Ainsi ces plaques peuvent être préparées par injection des compositions en cause, ce qui constitue un mode avantageux de réalisation de l'invention. Ces plaques avec ou sans inserts permettent des transferts thermiques améliorés, ce qui est un aspect de toute première importance à une époque où l'on vise de hautes densités de circuiterie. En outre sur les supports en question qui peuvent être non plans par suite de la présence en leur sein de bossages, d'inserts, de renforts....., il est possible de révéler par un borohydrure des surfaces conductrices et, par un processus extrèmement

simple à mettre en oeuvre, de construire un circuit imprimé.

Les circuits imprimés construits sur de telles plaques peuvent être exempts de sous-gravure ce qui contribue aussi à pouvoir augmenter la densité de la circuiterie et la fiabilité des circuits.

Les exemples suivants donnés à titre non limitatif illustrent l'invention et montrent comment elle peut être mise en oeuvre.

EXEMPLES 1 à 10

Le polymère en granulés ou en poudre est mélangé d'abord intimement avec 1 % d'un agent mouillant non ionique à base de lanoléine éthoxy éthylé (commercialisé sous le nom de CEMULSOL J) puis homogénéisé avec le même poids d'oxyde cuivreux en poudre de granulométrie moyenne 1 micrométre (provenance Prolabo). L'oxyde enrobe les grains de polymère ce qui permet d'assurer l'homogénité du mélange au cours de l'essai.

Les mélanges ainsi préparés sont ensuite passés dans une boudineuse double vis de diamètre D = 34 mm, de longueur 35 D de marque Leistritz équipée d'une filière de diamètre 5 mm, la vis tournant à 90 t/mn. A la sortie de la filière le jonc est refroidi dans un bain d'eau froide sur une longueur de 50 cm environ de manière que le jonc reste suffisamment chaud pour faire évaporer l'eau déposée en surface. (Le polyuréthanne trop mou à chaud a été séché en étuve à vide après granulation). Tous les joncs sont granulés. On trouvera sur le tableau suivant les conditions opératoires.

| Essais | Polymère | Marque | Séchage préalable | Température Moyenne boudineuse | Débit: kg/h |
|---|---|---|---|---|---|
| 1 | polyamide 6 | Diurethane BK 31 | pris dans caisse outre étanche | 290°C | 15 |
| 2 | polyamide 6-6 | Technyl 50 AP | pris dans caisse outre étanche | 290°C | 13,8 |
| 3 | PVDF | Foraflon 1000 HD | non séché | 250°C | 16,4 |
| 4 | PE - HD | Eltex B 3925 | non séché | 250°C | 9,5 |
| 5 | polycarbonate | Makrolon | non séché | 290°C | 14,4 |
| 6 | PEGT (*) | GTE 70 T | une nuit à 140° sous vide | 255°C | 6 |
| 7 | PBGT (**) | 90 YA | une nuit à 140° sous vide | 230°C | 9,5 |
| 8 | polyacétal | Hostaform 9021 | 3 h à 115°C sous vide | 230°C | 16 |
| 9 | polyuréthanne | Estane 57/14 | 3 h à 115°C sous vide | 180°C | 7,2 |
| 10 | résine époxy | Araldite Type F | non séché | *** | - |

* PEGT = polyéthylèneglycol téréphtalate

** PBGT = polybutylèneglycol téréphtalate

*** = coulée et cuisson 4 h à 80°C et 16 h à 120°C

Tous les joncs obtenus sont très homogènes et de bel aspect ce qui est le signe d'une bonne répartition de la charge dans la matrice.

Les granulés sont injectés dans un moule conduisant à des éprouvettes carrées de 6 cm de côté et de 2 mm d'épaisseur. On utilise pour ce faire une boudineuse sauf pour l'essai 10 où l'éprouvette est moulée selon les conditions précisées ci-avant.

Les conditions opératoires sont les suivantes :

| Essais | Température en °C | | | | | Temps de solidification en seconde |
|---|---|---|---|---|---|---|
| | Buse | fourreau 1 | fourreau 2 | trémie | moule | |
| 1 | 270 | 270 | 260 | 250 | 75 | 6 |
| 2 | 270 | 270 | 260 | 250 | 90 | 6 |
| 3 | 260 | 260 | 250 | 240 | 50 | 6 |
| 4 | 280 | 280 | 270 | 260 | 50 | 6 |
| 5 | 280 | 280 | 270 | 260 | 105 | 6 |
| 6 | 270 | 270 | 260 | 250 | 135 | 10 |
| 7 | 240 | 240 | 230 | 230 | 80 | 6 |
| 8 | 210 | 200 | 190 | 180 | 80 | 6 |
| 9 | 180 | 180 | 180 | 170 | ambiante | 6 |

On constate que toutes les éprouvettes ont fait l'objet d'un bon moulage et sont sans défaut.

On a remarqué que l'adjonction d'oxyde de cuivre accélère la

solidification des compositions fondues. Ainsi par exemple le temps de solidification de la composition à base de polyéthylèneglycol téréphtalate passe de 180 secondes pour le polymère seul à 10 secondes pour la composition chargée d'oxyde de cuivre.

La conductivité thermique a été mesurée sur des plaques obtenues à l'essai n°10 en époxy selon la norme NFX 10 021 légèrement modifiée pour tenir compte des dimensions différentes des échantillons à tester.

On obtient les résultats suivants.

| Eprouvettes | Epaisseur en mm | Température d'essai | Flux thermique en W | Conductivité thermique en W/m/°C |
|---|---|---|---|---|
| Epoxy Araldite F | 2,15 | 50°C | 3,1 | 0,20 |
| | | 100°C | 3,1 | 0,20 |
| Epoxy+50% $Cu_2O$ | 2,12 | 50°C | 3,1 | 0,40 |
| | | 100°C | 3,1 | 0,37 |

On constate que l'on a doublé la conductivité thermique en ajoutant à la composition 50 % en poids d'oxyde de cuivre.

EXEMPLE 11

Une des plaques réalisée dans l'exemple 2 est décapée superficiellement à l'aide d'un papier abrasif fin puis soigneusement dépoussiérée (par rincage à l'eau en cuve à ultrason). Le décapage superficiel est conduit de telle sorte que la pellicule brillante (film superficiel de résine pure) soit éliminée totalement. Après cette opération la charge d'oxyde de cuivre est accessible à la surface de la plaque et apte à subir l'opération de réduction chimique qui confère à la plaque une bonne conductibilité de surface.

La solution réductrice est préparée de la façon suivante :

Dans un erlen de 1000 ml on introduit dans l'ordre sous agitation et après dilution de chaque constituant :

- 500 ml d'eau distillée,

- 2,5 g de soude en pastilles,
- 5 g de sel de sodium d'une carboxyméthylcellulose (type 7ME, "medium viscosity", PM 250 000 d'HERCULES),
- 25 g de borohydrure de potassium,
- 5 $cm^3$ d'une solution aqueuse à 1 % de Cemulsol DB 311 de SFOS.

La plaque est enduite par la solution réductrice et après un contact de 3 mn la solution et les sous produits de la réaction sont éliminés par lavage à l'eau distillée accompagné d'un léger brossage. La plaque est rincée à l'alcool et séchée.

La plaque ainsi obtenue est alors soumise aux opérations permettant la fabrication d'un circuit imprimé :

- Dépôt de photorésist
- Insolation au travers de masque
- Développement du photorésist
- Renforcement électrolytique dans un bain acide de sulfate de cuivre avec anode de cuivre, dans les plages sans photorésist
- Lorsque l'épaisseur du dépôt atteint une trentaine de micromètres en moins d'une heure, le rincage à l'eau du circuit
- Strippage du photorésist restant
- Gravure non sélective au perchlorure de fer jusqu'à disparition complète du cuivre dans les zones non renforcées
- Après rinçage à l'eau, immersion rapide dans un bain d'acide sulfurique dilué pour redonner un aspect brillant au circuit
- Rinçage soigneux à l'eau distillée puis à l'alcool et enfin séchage.

Au terme de cette opération nous disposons d'un circuit imprimé de belle apparence, dont les pistes ont environ 60 micromètres de largeur et ne présentent pas de sous-gravure.

Le renforcement électrolytique a permis d'obtenir une épaisseur des pistes de 30 micromètres environ.

Mesurée sur une bande de 1 cm de largeur l'adhérence ou résistance à l'arrachement est de 1500g/cm.

## REVENDICATIONS

1) Procédé d'obtention de plaques supports de circuits imprimés par moulage d'une composition constituée essentiellement d'une matrice polymérique et d'au moins un oxyde métallique non conducteur dont le degré d'oxydation est choisi de manière à permettre une réduction facile par un borohydrure, le cas échéant en présence d'inserts et/ou de renforts.

2) Procédé d'obtention de plaques supports munies d'au moins un circuit imprimé caractérisé par la succession d'étapes suivantes :

a) on moule une composition constituée essentiellement d'une matrice polymérique et d'au moins un oxyde métallique non conducteur le cas échéant en présence d'inserts et/ou de renforts,

b) on décape la plaque ainsi obtenue, sur au moins l'une de ses faces, chimiquement ou mécaniquement,

c) on applique sur la surface un photorésist en laissant libre la surface du circuit à réaliser,

d) on réduit l'oxyde métallique par un borohydrure;

e) on renforce le cas échéant le(s) chemin(s) conducteur(s) par dépôt d'un métal approprié,

f) on élimine le photorésist,

g) le cas échéant, on coupe les pistes de jonction électrique,

3) Procédé d'obtention de plaques supports munies d'au moins un circuit imprimé caractérisé par la succession d'étapes suivantes :

a) on moule une composition constituée essentiellement d'une matrice polymérique et d'au moins un oxyde métallique non conducteur le cas échéant en présence d'inserts et/ou de renforts,

b) on décape la plaque ainsi obtenue, sur au moins l'une de ses faces, chimiquement ou mécaniquement,

c) on réduit l'oxyde métallique sur la surface décapée par un borohydrure ; puis le cas échéant,

d) on applique sur la surface un photorésist en laissant libre la surface correspondant un circuit à imprimer,

e) on renforce le(s) chemin(s) conducteur(s) par dépôt d'un métal approprié,

f) on élimine le photorésist,

g) on effectue une gravure non sélective pour rendre non conductrice la surface, excepté le circuit renforcé.

4) Procédé selon l'une quelconque des revendications 1 à 3 dans lequel le moulage est réalisé par injection d'une composition constituée essentiellement d'une matrice polymérique et d'au moins un oxyde métallique non conducteur dont le degré d'oxydation est choisi de manière à permettre une réduction facile par un borohydrure, le cas échéant en présence d'inserts et/ou de renforts, les particules d'oxyde ayant une granulométrie inférieure à 5 micromètres.

5) Procédé selon la revendication 4, caracatérisé en ce que la composition comprend de 10 à 70 % en poids d'oxyde cuivreux.

6) Procédé selon la revendication 2 ou 3 dans lequel à l'étape (a) on moule par injection une composition comprenant 10 à 70 % en poids d'oxyde cuivreux en poudre de granulométrie inférieure à 5 micromètres et à l'étape (e) on renforce le(s) chemin(s) conducteur(s) par electrodépôt d'un métal approprié.

7) Procédé selon la revendication 6, caractérisé en ce que l'électrodépôt est un cuivrage électrolytique.

8) Composition injectable destinée à la mise en oeuvre du procédé selon l'une quelconque des revendications précédentes constituée essentiellement, au moins d'une matière thermoplastique, thermodurcissable ou élastomérique ayant sous forme de prépolymère un comportement thermoplastique et de 10 à 70 % en poids sous forme de poudre dont la granulométrie est comprise entre 0,1 et 5 micromètres.

9) Plaques support de circuits imprimés, éventuellement munies d'un circuit imprimé obtenues selon l'une quelconques des revendications 1 à 7.

10) Plaques selon la revendication 9 comportant au moins une face non plane.

REVENDICATIONS Autriche

1) Procédé d'obtention de plaques supports de circuits imprimés par moulage d'une composition constituée essentiellement d'une matrice polymérique et d'au moins un oxyde métallique non conducteur dont le degré d'oxydation est choisi de manière à permettre une réduction facile par un borohydrure, le cas échéant en présence d'inserts et/ou de renforts.

2) Procédé d'obtention de plaques supports munies d'au moins un circuit imprimé caractérisé par la succession d'étapes suivantes :

a) on moule une composition constituée essentiellement d'une matrice polymérique et d'au moins un oxyde métallique non conducteur le cas échéant en présence d'inserts et/ou de renforts,
b) on décape la plaque ainsi obtenue, sur au moins l'une de ses faces, chimiquement ou mécaniquement,
c) on applique sur la surface un photorésist en laissant libre la surface du circuit à réaliser,
d) on réduit l'oxyde métallique par un borohydrure;
e) on renforce le cas échéant le(s) chemin(s) conducteur(s) par dépôt d'un métal approprié,
f) on élimine le photorésist,
g) le cas échéant, on coupe les pistes de jonction électrique,

3) Procédé d'obtention de plaques supports munies d'au moins un circuit imprimé caractérisé par la succession d'étapes suivantes :

a) on moule une composition constituée essentiellement d'une matrice polymérique et d'au moins un oxyde métallique non conducteur le cas échéant en présence d'inserts et/ou de renforts,
b) on décape la plaque ainsi obtenue, sur au moins l'une de ses faces, chimiquement ou mécaniquement,
c) on réduit l'oxyde métallique sur la surface décapée par un borohydrure ; puis le cas échéant,
d) on applique sur la surface un photorésist en laissant libre la surface correspondant un circuit à imprimer,

e) on renforce le(s) chemin(s) conducteur(s) par dépôt d'un métal approprié,

f) on élimine le photorésist,

g) on effectue une gravure non sélective pour rendre non conductrice la surface, excepté le circuit renforcé.

4) Procédé selon l'une quelconque des revendications 1 à 3 dans lequel le moulage est réalisé par injection d'une composition constituée essentiellement d'une matrice polymérique et d'au moins un oxyde métallique non conducteur dont le degré d'oxydation est choisi de manière à permettre une réduction facile par un borohydrure, le cas échéant en présence d'inserts et/ou de renforts, les particules d'oxyde ayant une granulométrie inférieure à 5 micromètres.

5) Procédé selon la revendication 4, caracatérisé en ce que la composition comprend de 10 à 70 % en poids d'oxyde cuivreux.

6) Procédé selon la revendication 2 ou 3 dans lequel à l'étape (a) on moule par injection une composition comprenant 10 à 70 % en poids d'oxyde cuivreux en poudre de granulométrie inférieure à 5 micromètres et à l'étape (e) on renforce le(s) chemin(s) conducteur(s) par electrodépôt d'un métal approprié.

7) Procédé selon la revendication 6, caractérisé en ce que l'électrodépôt est un cuivrage électrolytique.